# EUROPEAN PATENT APPLICATION

(11) **EP 4 704 144 A1**
(43) Date of publication of application: **04.03.2026**
(21) Application number: 24219802.6
(22) Date of filing: 13.12.2024
(51) Int. Cl.: H01L 21/67

(54) **METHOD AND APPARATUS FOR NANOFLUID WET CLEANSING WAFER**

(30) Priority: 02.09.2024 KR 20240118705
(71) Applicant: UNIVERSITY OF ULSAN FOUNDATION FOR INDUSTRY COOPERATION, Nam-gu Ulsan 44610 (KR)
(72) Inventor: KIM, Bo Hung, 44610 Ulsan (KR); MASUDUZZAMAN, Md, 44610 Ulsan (KR); HOSSAIN, Jaber Al, 44610 Ulsan (KR); KARIM, Kazi Ehsanul, 44610 Ulsan (KR); LEE, Seongmin, 44610 Ulsan (KR); WOO, Jun Sik, 44610 Ulsan (KR)
(74) Representative: Zacco Sweden AB

(57) **Abstract**

Provided are a wafer cleaning method capable of uniformly cleaning an entire area of a wafer, and a wafer cleaning apparatus to which the method is applied. The method includes positioning a cleaning tool so as to face a surface of the wafer requiring cleaning; supplying a cleaning liquid containing ions to an area between the surface of the wafer and the cleaning tool; adjusting a spacing between the surface of the wafer and the cleaning tool so that a viscosity of the cleaning liquid present between the surface of the wafer and the cleaning tool is controlled under an electric field; and rotating the wafer and the cleaning tool relatively to each other in a state in which the electric field has been applied to at least a portion of an area in which the cleaning liquid is present, thereby cleaning the surface of the wafer with the cleaning liquid.

## Description

### BACKGROUND

### Field

This achievement is a study conducted with the support of the National Research Foundation of Korea (RS-2023-00272214) funded by the Korean government (Ministry of Science and ICT).

The present disclosure relates to a wafer cleaning method capable of uniformly wet-cleaning an entire area of a wafer using a nano fluid, and a wafer cleaning apparatus to which the method is applied.

### Description of Related Art

Semiconductor manufacturing technology is developing day by day toward ultra-fine processes. Accordingly, the development of manufacturing technology capable of micro-processes of several nanoscales is currently being made. In nanoscale, the behavior of each fluid particle affects the flow of the fluid such that the affecting cannot be explained based on the continuous equation of the fluid. Accordingly, in each step of the semiconductor manufacturing process in which the scale as dealt with has reached the nano-scale, it becomes difficult to design a process that may be predicted or modeled conventionally.

For example, in semiconductor manufacturing processes such as cleaning, deposition, and etching, the flow of a fluid such as a liquid or gas should be predicted. Conventionally, based on fluid dynamics and data accumulated over the decades, the above prediction and corresponding design were possible. However, as the design level has reached the nano-scale, the previous prediction scheme was no longer valid. On the other hand, in the semiconductor manufacturing in the ultra-fine process, the ultra-fine structure is built on the wafer as the process proceeds. In addition, between the respective processes, a cleaning process is performed to remove by-products of the previous process. Since the particles removed in the cleaning process exist between ultra-fine structures, the cleaning thereof is not easy. For example, when the cleaning is excessively performed to remove foreign substances or particles that is not easy to clean, there is a concern that the patterning structure of the semiconductor may be damaged.

Moreover, due to the characteristics of the cleaning process normally performed while rotating a semiconductor wafer, cleaning is excessively performed on an area disposed further outwardly in a radial direction from a center of rotation, whereas cleaning is insufficient on an area close to the center of rotation. That is, in order to sufficiently clean the area close to the center of rotation, cleaning is inevitably performed excessively on the area disposed radially outwardly in a radial direction from the center of rotation.

Accordingly, the cleaning is performed while generating high-frequency vibration in the cleaning liquid without using a brush. However, this scheme also cannot avoid the cleaning force deviation occurring in the radial direction. Moreover, when high-frequency energy is not absorbed into an entirety of the cleaning liquid but is transferred to the patterning structure of the semiconductor, the patterning structure may be damaged.

### SUMMARY

The present disclosure has been devised to solve the above-described problems. Thus, a purpose of the present disclosure is to provide a wafer cleaning method and a wafer cleaning apparatus using the same, in which cleaning of a wafer may be performed uniformly over the entire area thereof regardless of a radial position thereof in a wet wafer cleaning process corresponding to an ultrafine process.

A purpose of the present disclosure is to provide a wafer cleaning method capable of minimizing a difference in cleaning power along change in a radial position when wet-cleaning is performed in a rotation scheme, and a wafer cleaning apparatus using the same.

A purpose of the present disclosure is to provide a wafer cleaning method applicable to an ultra-fine process without major change to a typical wafer wet-cleaning method and a wafer cleaning apparatus using the same.

Purposes according to the present disclosure are not limited to the above-mentioned purpose. Other purposes and advantages according to the present disclosure that are not mentioned may be understood based on following descriptions, and may be more clearly understood based on embodiments according to the present disclosure. Further, it will be easily understood that the purposes and advantages according to the present disclosure may be realized using means shown in the claims or combinations thereof.

In order to achieve the above-described purpose, the wet-cleaning method of the wafer of the present disclosure may be applied to the cleaning of the wafer in the rotating scheme.

The wet-cleaning method applies an electric field varying based on a position in a radial direction to an ion cleaning liquid supplied to an area between the surface of the wafer and the cleaning tool. The electric field is based on a direct current power source.

Accordingly, the viscosity of the cleaning liquid is artificially controlled based on different areas, so that the cleaning may be performed equally on areas having different radial distances from the rotation center during the rotational cleaning.

Specifically, the wafer cleaning method includes a first step of positioning a cleaning tool so as to face a surface of the wafer requiring cleaning.

The wafer cleaning method further includes a second step of supplying a cleaning liquid containing ions to an area between the surface of the wafer and the cleaning tool.

The wafer cleaning method further includes a third step of adjusting a spacing between the surface of the wafer and the cleaning tool so that a viscosity of the cleaning liquid present between the surface of the wafer and the cleaning tool is controlled under an electric field.

The wafer cleaning method further includes a fourth step of rotating the wafer and the cleaning tool relatively to each other in a state in which the electric field has been applied to at least a portion of an area in which the cleaning liquid is present, thereby cleaning the surface of the wafer with the cleaning liquid.

In one embodiment of the method, the area in which the cleaning liquid is present includes a first area and a second area, wherein a distance between the first area and the rotational center is smaller than a distance between the second area and the rotational center.

In one embodiment, an electric field may be applied to the first area so that the viscosity of the cleaning liquid in the first area is greater than the viscosity of the cleaning liquid in the second area.

In an example, an intensity of an electric field applied to the first area may be greater than an intensity of an electric field applied to the second area.

In another example, an electric field may be applied to the first area, and no electric field may be applied to the second area.

In one embodiment, an intensity distribution of the electric field applied to the area includes a first distribution in which the intensity decreases as the area extends away from the rotational center.

In one embodiment, an intensity distribution of the electric field applied to the area includes a first distribution in which the intensity gradually decreases as the area extends away from the rotational center.

In one embodiment, an intensity distribution of the electric field applied to the area includes a second distribution in which the intensity continuously decreases as the area extends away from the rotational center.

In one embodiment, an intensity distribution of the electric field applied to the area includes a third distribution in which the intensity decreases in a stepwise manner as the area extends away from the rotational center.

In one embodiment, an intensity distribution of the electric field applied to the area includes a fourth distribution in which the intensity linearly decreases as the area extends away from the rotational center.

In one embodiment, an intensity distribution of the electric field applied to the area including a fifth distribution in which the intensity decreases non-linearly as the area extends away from the rotational center.

In one embodiment, the intensity distribution of the electric field applied to the area may including a sixth distribution in which the intensity decreases in a parabolic shape as the area extends away from the rotational center.

In one embodiment, the intensity distribution of the electric field applied to the area may including a seventh distribution in which the intensity decreases in a hyperbolic shape as the area extends away from the rotational center.

The intensity distribution of the electric field applied to the area may include at least one of the first to seventh distributions.

In one embodiment, the cleaning liquid includes a H₂O solution containing cations and anions.

In one embodiment, the cation and the anion include Na⁺ and Cl⁻ ions.

In one embodiment, in the cleaning liquid, the cations and the anions may be equivalent to each other so that the cleaning liquid becomes neutral.

In one embodiment, an equivalent concentration of the ions contained in the cleaning liquid is in a range of 0.1Meg/L inclusive to 10 Meg/L inclusive.

In this regard, when the equivalent concentration of the ions is lower than 0. 1Meg/L, there is little change in the viscosity of the cleaning liquid even when the intensity of the electric field is controlled, thereby making it difficult to control the viscosity.

When the equivalent concentration of the ions is greater than 10 Meg/L, the effect of inducing a change in viscosity of the cleaning liquid under the intensity of the electric field is not further increased, and there is a concern that the possibility that the ions remain as foreign substances may increase.

In one embodiment, an equivalent concentration of the ions contained in the cleaning liquid is in a range of 1.0Meg/L inclusive to 2.0 Meg/L inclusive. More preferably, the equivalent concentration of the ions may be about 1.5 Meg/L.

In one embodiment, the spacing is in range of 1 nm inclusive to 20nm inclusive. An area corresponding to the spacing may be filled with the cleaning liquid.

In this regard, when the spacing is smaller than 1 nm, it is difficult to fill the cleaning liquid within the spacing, whereas the effect of inducing the change in viscosity of the cleaning liquid based on the intensity of the electric field is no longer increased.

When the spacing exceeds 20nm, the cleaning liquid having the height of 20nm has little change in viscosity even when the intensity of the electric field is controlled, thereby making it difficult to control the viscosity.

In one embodiment, the spacing is in a range of 2 nm inclusive to 4 nm inclusive. More preferably, the spacing may be about 3 nm.

The present disclosure provides a wafer cleaning apparatus to which the wet-cleaning method of the wafer is applied.

The wafer cleaning apparatus includes a wafer support for gripping the wafer; a cleaning tool positioned to face the wafer support; a cleaning liquid supply device for supplying a cleaning liquid containing ions to an area between the cleaning tool and the wafer support; a driver device configured to rotate the wafer support and the cleaning tool relatively to each other; and an electric field applicator configured to apply an electric field to the cleaning liquid supplied onto the wafer. The electric field is based on a direct current power source.

The cleaning device may further include a spacing adjusting device for adjusting a spacing between the surface of the wafer and the cleaning tool.

The wafer support may rotate around a predetermined rotational center.

The rotational center may extend in the vertical direction. The wafer support may extend in a horizontal direction.

The wafer support may support one or two or more wafers.

In the wafer support supporting one wafer, a center of the wafer may be aligned with a rotational center of the wafer support.

In the wafer support supporting two or more wafers, the wafers may be arranged so as to be spaced from each other by an equal angular spacing along the circumferential direction of the wafer support.

The wafer support may support the wafer so that the surface of the wafer requiring cleaning faces in the vertical direction.

The cleaning surface of the cleaning tool may face the surface of the wafer in the vertical direction.

In one embodiment, the cleaning surface may have a length smaller than a diameter of the wafer support and larger than a radius thereof.

In one embodiment, a width of the cleaning surface measured in a circumferential direction of the wafer support may be maintained constant along the radial direction of the wafer support.

In one embodiment, the width of the cleaning surface measured in the circumferential direction of the wafer support may gradually increase as the cleaning surface extends radially and outwardly of the wafer support. Thus, the cleaning surface may have a fan shape.

In one embodiment, the shape of the cleaning surface may be circular. The diameter of the cleaning surface may substantially correspond to the diameter of the wafer support or may substantially correspond to the radius of the wafer support.

The spacing adjusting device may move the cleaning tool in a vertical direction. The vertical direction may be a direction perpendicular to the surface of the wafer.

In one embodiment, the cleaning surface of the cleaning tool may include a brush.

In one embodiment, the cleaning surface of the cleaning tool may be a vibrating plate that causes vibration.

In one embodiment, the cleaning liquid supply device may supply the cleaning liquid to a position near the central portion of the wafer support.

In one embodiment, the cleaning liquid supply device may be embodied in a form of a showerhead extending outwardly in a radial direction from a central portion of the wafer support.

The driver device may include a rotor positioned at the rotational center of the wafer support and connected to the wafer support and extending in an axial direction, and a stator rotating the rotor.

In one example, the driver device may rotate the wafer support at a speed of 20 to 50 rpm.

The electric field applicator may include conductive plates arranged in a matrix form.

The electric field applicator may apply an electric field to a space between the wafer support and the cleaning tool to which the cleaning liquid is supplied.

The electric field applicator may be received in the cleaning tool.

Still another aspect of the present disclosure provides a method for wet-cleaning a wafer, the method comprising: a first step of positioning a cleaning tool so as to face a surface of the wafer requiring cleaning; a second step of supplying a cleaning liquid containing ions to an area between the surface of the wafer and the cleaning tool; a third step of adjusting a spacing between the surface of the wafer and the cleaning tool so that a viscosity of the cleaning liquid present between the surface of the wafer and the cleaning tool is controlled under an electric field; and a fourth step of rotating the wafer and the cleaning tool relatively to each other in a state in which the electric field has been applied to at least a portion of an area in which the cleaning liquid is present, thereby cleaning the surface of the wafer with the cleaning liquid.

In one embodiment of the method, the area in which the cleaning liquid is present includes a first area and a second area, wherein a distance between the first area and the rotational center is smaller than a distance between the second area and the rotational center.

In one embodiment of the method, the electric field is applied to the cleaning liquid of the first area in the fourth step.

In one embodiment of the method, the electric field is further applied to the cleaning liquid of the second area.

In one embodiment of the method, an intensity of the electric field applied to the first area is greater than an intensity of the electric field applied to the second area.

In one embodiment of the method, the electric field is applied to the first area and no electric field is applied to the second area.

In one embodiment of the method, in the fourth step, an intensity distribution of the electric field applied to the area includes a distribution in which the intensity gradually decreases as the area extends away from the rotational center.

In one embodiment of the method, in the fourth step, an intensity distribution of the electric field applied to the area includes a distribution in which the intensity continuously decreases as the area extends away from the rotational center.

In one embodiment of the method, in the fourth step, an intensity distribution of the electric field applied to the area includes a distribution in which the intensity decreases in a stepwise manner as the area extends away from the rotational center.

In one embodiment of the method, in the fourth step, an intensity distribution of the electric field applied to the area includes a distribution in which the intensity linearly decreases as the area extends away from the rotational center.

In one embodiment of the method, in the fourth step, an intensity distribution of the electric field applied to the area including a distribution in which the intensity decreases non-linearly as the area extends away from the rotational center.

In one embodiment of the method, the cleaning liquid includes a H₂O solution containing cations and anions.

In one embodiment of the method, the cation and the anion include Na⁺ and Cl- ions.

In one embodiment of the method, an equivalent concentration of the ions contained in the cleaning liquid is in a range of 0. 1Meg/L inclusive to 10 Meg/L inclusive.

In one embodiment of the method, an equivalent concentration of the ions contained in the cleaning liquid is in a range of 1.0Meg/L inclusive to 2.0 Meg/L inclusive.

In one embodiment of the method, the spacing is in range of 1 nm inclusive to 20nm inclusive.

In one embodiment of the method, the spacing is in a range of 2 nm inclusive to 4 nm inclusive.

Still another aspect of the present disclosure provides an apparatus for wet-cleaning a wafer, the apparatus comprising: a wafer support for gripping the wafer; a cleaning tool positioned to face the wafer support; a cleaning liquid supply device for supplying a cleaning liquid containing ions to an area between the cleaning tool and the wafer support; a spacing adjusting device for adjusting a spacing between the wafer support and the cleaning tool to adjust a height of the cleaning liquid present between a surface of the wafer and the cleaning tool; a driver device configured to rotate the wafer support and the cleaning tool relatively to each other; and an electric field applicator configured to apply an electric field to the cleaning liquid supplied onto the wafer.

In one embodiment of the apparatus, the area in which the cleaning liquid is present includes a first area and a second area, wherein a distance between the first area and the rotational center is smaller than a distance between the second area and the rotational center.

In one embodiment of the apparatus, the electric field applicator is configured to apply the electric fields having different intensities to the first area and the second area, respectively.

In one embodiment of the apparatus, the electric field applicator is configured to apply the electric field to the first area and not to apply the electric field to the second area.

In one embodiment of the apparatus, the electric field applicator is configured to apply the electric field to the cleaning liquid so that an intensity of the electric field applied to the area decreases as the area extends away from the rotational center.

In one embodiment of the apparatus, the electric field applicator is configured to apply the electric field based on a direct current power source.

According to the present disclosure, in the wet wafer cleaning process in the rotating scheme corresponding to the ultrafine process, an electric field having varying intensity based on the areas may be applied to different areas of the cleaning liquid containing ions to control the viscosity of the cleaning liquid based on the areas, such that uniform cleaning throughout the cleaning target area of the wafer may be achieved.

According to the present disclosure, the intensity of the electric field to be applied to each of the areas may be calculated accurately based on the concentration of ions in the cleaning liquid, the height of the cleaning liquid, the rotation speed, and the distance between the electric field application target area and the center of rotation, and the electric field having the calculated intensity may be applied to each of the areas.

The effects of the present disclosure are not limited to the effects mentioned above, and other effects not mentioned will be clearly understood by those skilled in the art from the description below.

### BRIEF DESCRIPTION OF DRAWINGS

FIG. 1 is a perspective view of a wafer cleaning apparatus of an embodiment according to the present disclosure.
FIG. 2 is a front cross-sectional view of the wafer cleaning apparatus of FIG. 1.
FIG. 3 is a perspective view showing a cleaning tool and an electric field applicator of the wafer cleaning device of FIG. 1.
FIG. 4 is a perspective view showing a cleaning liquid supply device of the wafer cleaning apparatus of FIG. 1.
FIG. 5 is a perspective view showing a wafer support and a driver device of the wafer cleaning apparatus of FIG. 1.
FIG. 6 is a perspective view showing a state in which a wafer is concentrically mounted on the wafer support of FIG. 5.
FIG. 7 is a perspective view showing a state in which a plurality of wafers are eccentrically mounted on the wafer support of FIG. 5.
FIG. 8 is a perspective view showing a state in which the cleaning tool of a first embodiment is disposed on the wafer support of FIG. 5.
FIG. 9 is a perspective view showing a state in which the cleaning tool of a second embodiment is disposed on the wafer support of FIG. 5.
FIG. 10 is a perspective view showing a state in which the cleaning tool of a third embodiment is disposed on the wafer support of FIG. 5.
FIG. 11 is a perspective view showing a state in which the cleaning tool of a fourth embodiment is disposed on the wafer support of FIG. 5.
FIG. 12 is an enlarged view of a box .12. of FIG. 2.
FIG. 13 is a graph showing a linear velocity of a wafer surface based on a distance from a center of rotation to a specific position of the wafer surface.
FIG. 14 is a graph showing a first embodiment of a distribution of an applied electric field intensity based on a distance from the center of rotation to a specific area of a cleaning liquid supplied onto the wafer surface.
FIG. 15 is a graph showing a second embodiment of a distribution of an applied electric field intensity based on the distance from the center of rotation to the specific area of the cleaning liquid supplied onto the wafer surface.
FIG. 16 is a graph showing a third embodiment of the distribution of the applied electric field intensity based on the distance from the center of rotation to the specific area of the cleaning liquid supplied onto the wafer surface.
FIG. 17 is a graph showing a fourth embodiment of the distribution of the applied electric field intensity based on the distance from the center of rotation to the specific area of the cleaning liquid supplied onto the wafer surface.

### DETAILED DESCRIPTIONS

Hereinafter, a preferred embodiment of the present disclosure will be described in detail with reference to the accompanying drawings. Advantages and features of the present disclosure, and a method of achieving the advantages and features will become apparent with reference to embodiments described below in detail together with the accompanying drawings. However, the present disclosure is not limited to the embodiments as disclosed below, but may be implemented in various different forms. Thus, these embodiments are set forth only to make the present disclosure complete, and to entirely inform the scope of the present disclosure to those of ordinary skill in the technical field to which the present disclosure belongs, and the present disclosure is only defined by the scope of the claims.

For simplicity and clarity of illustration, elements in the drawings are not necessarily drawn to scale. The same reference numbers in different drawings represent the same or similar elements, and as such perform similar functionality. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. Examples of various embodiments are illustrated and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims.

A shape, a size, a ratio, an angle, a number, etc. disclosed in the drawings for illustrating embodiments of the present disclosure are illustrative, and the present disclosure is not limited thereto.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of associated listed items.

Expression such as "at least one of" when preceding a list of elements may modify the entire list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when a first element or layer is referred to as being "connected to", or "coupled to" a second element or layer, the first element may be directly connected to or coupled to the second element or layer, or one or more intervening elements or layers may be present therebetween. In addition, it will also be understood that when an element or layer is referred to as being "between" two elements or layers, it may be the only element or layer between the two elements or layers, or one or more intervening elements or layers may also be present therebetween.

In descriptions of temporal relationships, for example, temporal precedent relationships between two events such as "after", "subsequent to", "before", etc., another event may occur therebetween unless "directly after", "directly subsequent" or "directly before" is not indicated.

When a certain embodiment may be implemented differently, a function or an operation specified in a specific block may occur in a different order from an order specified in a flowchart. For example, two blocks in succession may be actually performed substantially concurrently, or the two blocks may be performed in a reverse order depending on a function or operation involved.

It will be understood that, although the terms "first", "second", "third", and so on may be used herein to describe various elements, components, areas, layers and/or periods, these elements, components, areas, layers and/or periods should not be limited by these terms. These terms are used to distinguish one element, component, area, layer or section from another element, component, area, layer or section. Thus, a first element, component, area, layer or section as described under could be termed a second element, component, area, layer or section, without departing from the spirit and scope of the present disclosure.

When an embodiment may be implemented differently, functions or operations specified within a specific block may be performed in a different order from an order specified in a flowchart. For example, two consecutive blocks may actually be performed substantially simultaneously, or the blocks may be performed in a reverse order depending on related functions or operations.

The features of the various embodiments of the present disclosure may be partially or entirely combined with each other, and may be technically associated with each other or operate with each other. The embodiments may be implemented independently of each other and may be implemented together in an association relationship.

In interpreting a numerical value, the value is interpreted as including an error range unless there is no separate explicit description thereof.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, "embodiments," "examples," "aspects, and the like should not be construed such that any aspect or design as described is superior to or advantageous over other aspects or designs.

Further, the term 'or' means 'inclusive or' rather than 'exclusive or'. That is, unless otherwise stated or clear from the context, the expression that 'x uses a or b' means any one of natural inclusive permutations.

The terms used in the description as set forth below have been selected as being general and universal in the related technical field. However, there may be other terms than the terms depending on the development and/or change of technology, convention, preference of technicians, etc. Therefore, the terms used in the description as set forth below should not be understood as limiting technical ideas, but should be understood as examples of the terms for illustrating embodiments.

Further, as used herein, when a layer, film, area, plate, or the like is disposed "on" or "on a top" of another layer, film, area, plate, or the like, the former may directly contact the latter or still another layer, film, area, plate, or the like may be disposed between the former and the latter. As used herein, when a layer, film, area, plate, or the like is directly disposed "on" or "on a top" of another layer, film, area, plate, or the like, the former directly contacts the latter and still another layer, film, area, plate, or the like is not disposed between the former and the latter. Further, as used herein, when a layer, film, area, plate, or the like is disposed "below" or "under" another layer, film, area, plate, or the like, the former may directly contact the latter or still another layer, film, area, plate, or the like may be disposed between the former and the latter. As used herein, when a layer, film, area, plate, or the like is directly disposed "below" or "under" another layer, film, area, plate, or the like, the former directly contacts the latter and still another layer, film, area, plate, or the like is not disposed between the former and the latter.

Further, in a specific case, a term may be arbitrarily selected by the applicant, and in this case, the detailed meaning thereof will be described in a corresponding description period. Therefore, the terms used in the description as set forth below should be understood based on not simply the name of the terms, but the meaning of the terms and the contents throughout the Detailed Descriptions.

Throughout the present disclosure, "A and/or B" means A, B, or A and B, unless otherwise specified, and "C to D" means C inclusive to D inclusive unless otherwise specified.

Hereinafter, a wafer cleaning apparatus according to an embodiment of the present disclosure and a wafer cleaning method implemented using the wafer cleaning apparatus will be described.

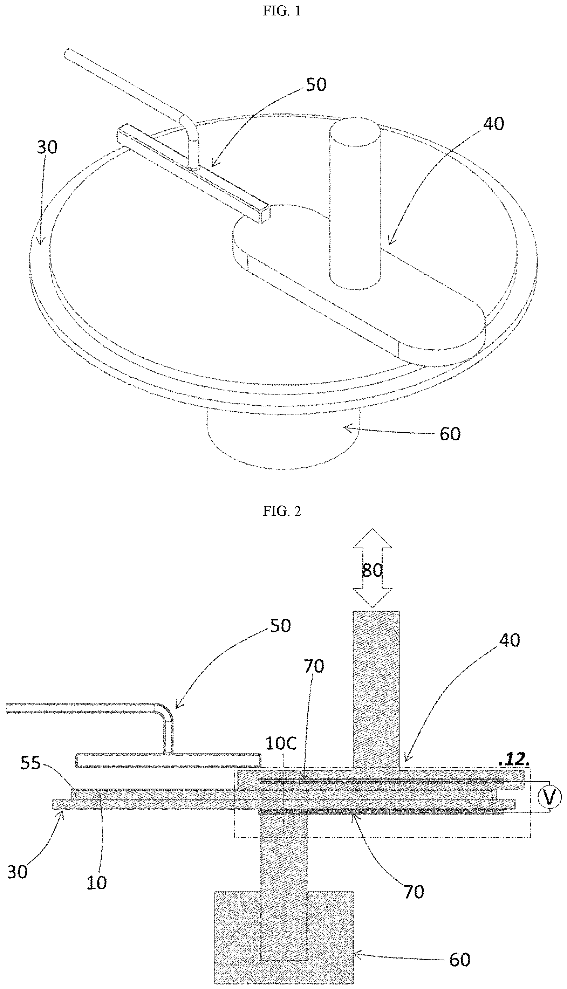

Referring to FIG. 1 to FIG. 12, the present disclosure provides a wafer cleaning apparatus to which a wet-cleaning method of a wafer 10 is applied. The wafer cleaning apparatus including a wafer support 30 for holding the wafer 10, a cleaning tool 40 facing the wafer support 30, a cleaning liquid supply device 50 for supplying a cleaning liquid 55 to an area between the cleaning tool 40 and the wafer support 30, a driver device 60 for relatively rotating the wafer support 30 and the cleaning tool 40 to each other, and an electric field applicator 70 for applying an electric field to the cleaning liquid 55.

Additionally, the wafer cleaning apparatus further including a spacing adjusting device 80 that adjusts a spacing between a surface of the wafer 10 and the cleaning tool 40.

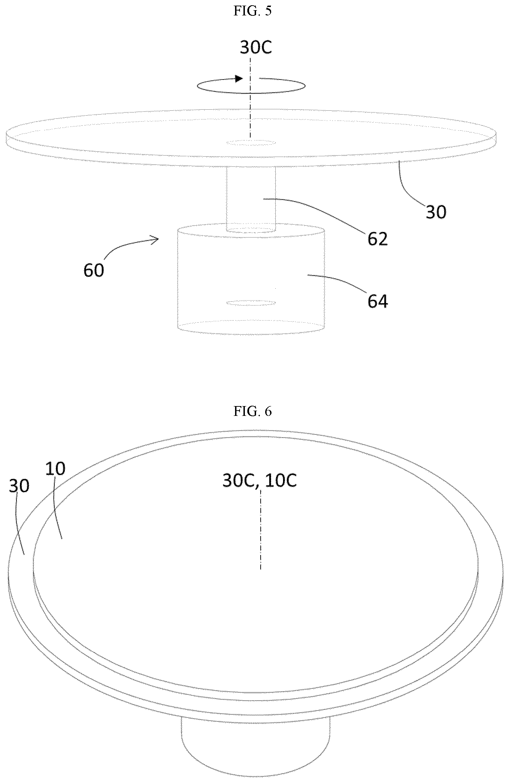

Referring to FIG. 5, the wafer support 30 is installed to be rotatable around a predetermined rotational center 30C. The rotational center 30C extends in a vertical direction, and the wafer support 30 extends in a horizontal direction. The wafer support 30 is rotatably driven by the driver device 60.

The driver device 60 includes a rotor 62 positioned at the rotational center 30C of the wafer support 30 and connected to the wafer support 30 and extending in an axial direction, and a stator 64 rotating the rotor 62. The axial direction of the rotor 62 may extend parallel to the vertical direction. For example, the driver device 60 may rotate the wafer support 30 at a speed of 20 to 50 rpm. However, the rotation speed of the wafer support 30 is not limited thereto.

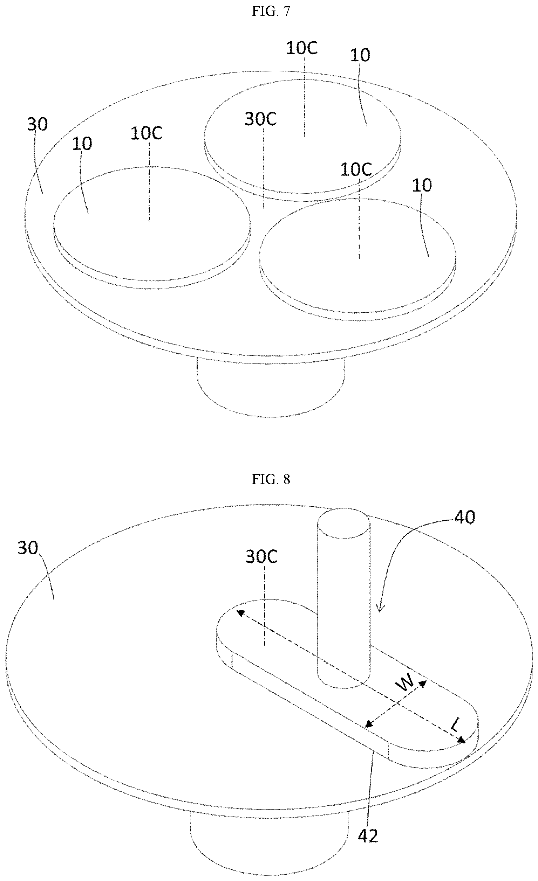

Referring to FIG. 6 and FIG. 7, the wafer support 30 supports one or more wafers 10 thereon. The wafer support 30 supports the wafer 10 thereon so that the surface of the wafer 10 requiring cleaning faces in the vertical direction.

As shown in FIG. 6, when the wafer support 30 supports one wafer 10, the wafer center 10C of the wafer 10 may be aligned with the rotational center 30C of the wafer support 30. Next, as shown in FIG. 7, when the wafer support 30 supports two or more wafers 10, the wafer centers 10C of the wafers 10 may be eccentrical with respect to the rotational center 30C of the wafer support 30, and may be arranged so as to be spaced from each other by an equal angular spacing along a circumferential direction of the wafer support 30. The embodiment illustrates that three wafers 10 are supported on the wafer support 30.

Referring to FIG. 8 to FIG. 11, a cleaning surface 42 of the cleaning tool 40 faces an upper surface of the wafer support 30 in the vertical direction. Accordingly, the cleaning surface 42 faces the surface of the wafer 10 gripped on the wafer support 30.

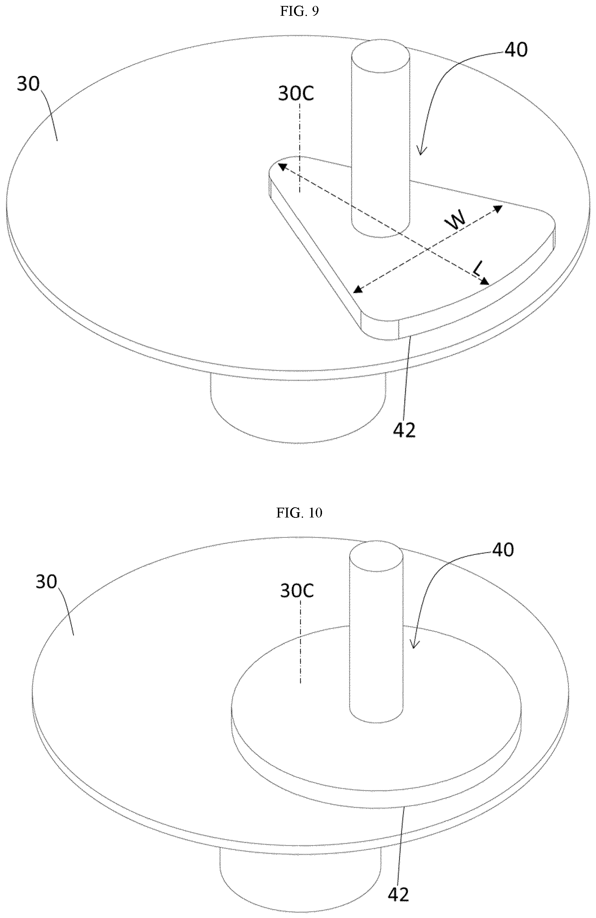

Referring to FIG. 8 and FIG. 9, in some embodiments, the cleaning surface 42 has a length L that is smaller than a diameter of the wafer support 30 and larger than a radius thereof.

Referring to FIG. 8, in some embodiments, a width W of the cleaning surface 42 measured in the circumferential direction of the wafer support 30 is maintained constant along a radial direction of the wafer support 30. For example, the cleaning surface 42 may have a track shape.

Referring to FIG. 9, in some embodiments, the width W of the cleaning surface 42 measured in the circumferential direction of the wafer support 30 may gradually increase as the cleaning surface 42 extends radially and outwardly of the wafer support 30. Thus, the cleaning surface 42 may have a fan shape.

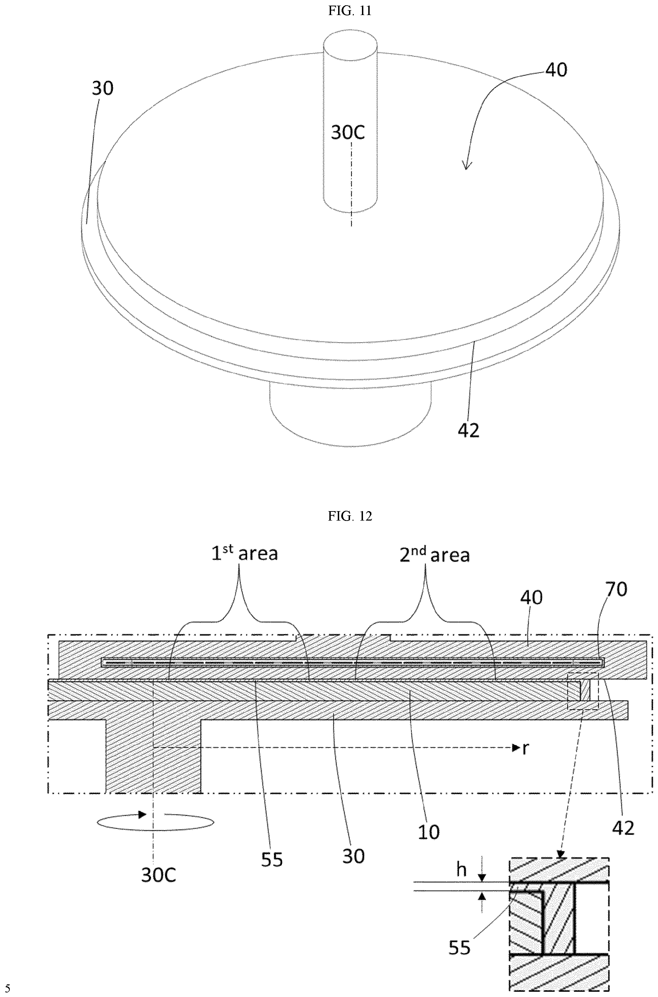

Referring to FIG. 10 and FIG. 11, in some embodiments, the shape of the cleaning surface 42 may be circular. Referring to FIG. 10, in some embodiments, the diameter of the cleaning surface 42 may substantially correspond to the radius of the wafer support 30. Referring to FIG. 11, in some embodiments, the diameter of the cleaning surface 42 may substantially correspond to the diameter of the wafer support 30.

In some embodiments, the cleaning surface 42 of the cleaning tool 40 includes a brush.

In some embodiments, the cleaning surface 42 of the cleaning tool 40 includes a vibrating plate that causes vibration.

In some embodiments, the cleaning surface 42 of the cleaning tool 40 includes the brush installed on the vibrating plate.

Referring to FIG. 2, the spacing adjusting device 80 may move the cleaning tool 40 in the vertical direction, that is, a direction perpendicular to the surface of the wafer. The spacing adjusting device 80 may vertically move the cleaning tool 40 to adjust the spacing between the cleaning surface 42 and the upper surface of the wafer 10 gripped on the wafer support 30.

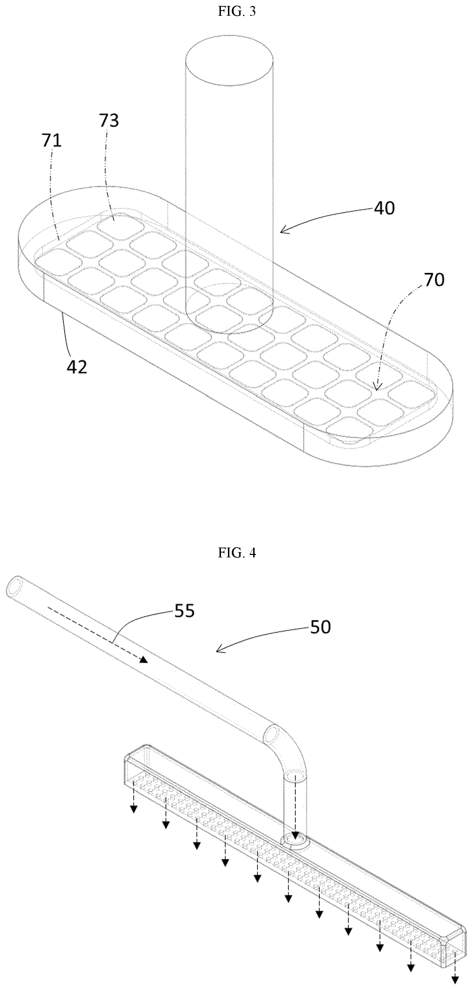

Referring to FIG. 1 and FIG. 2, the cleaning liquid supply device 50 supplies the cleaning liquid 55 to the wafer 10 gripped on the wafer support 30 at a position thereof near a central portion of the wafer support 30. As shown in FIG. 4, the cleaning liquid supply device 50 may be embodied in a form of a showerhead extending outwardly in the radial direction from the central portion of the wafer support 30. However, the form of the cleaning liquid supply device 50 is not limited thereto. For example, the cleaning liquid supply device 50 may be embodied in a form of a nozzle for supplying the cleaning liquid to the central portion of the wafer support 30.

Referring to FIG. 3, in some embodiments, the electric field applicator 70 includes conductive plates 73 arranged in a matrix form. The electric field applicator 70 includes a housing 71 in which the conductive plates are received. The electric field applicator 70 may apply an electric field to a space between the wafer support 30 and the cleaning tool 40 where the cleaning liquid 55 is supplied. That is, the electric field applicator 70 applies the electric field to the cleaning liquid 55.

The electric field applicator 70 may apply different voltages to the conductive plates 73, respectively. That is, the electric field applicator 70 includes a plurality of electric field application areas capable of applying different electric fields, respectively.

An embodiment illustrates that separate conductive plates are arranged in a matrix form to constitute the electric field applicator 70. However, this is an example, and various forms suitable for generating the electric field may be applied to the electric field applicator. For example, the cleaning surface 42 itself may be made of a conductive plate divided into a plurality of areas, and different voltages may be applied to different areas. In addition, the division scheme may also vary.

In some embodiments, the electric field applicator 70 is received in the cleaning tool 40 and is disposed under the wafer support 30. Even when the wafer support 30 rotates, the electric field applicator 70 maintains its place. The electric field applicator 70 is disposed adjacent to the cleaning surface 42 of the cleaning tool 40 to apply a strong electric field to the cleaning liquid 55 existing under the cleaning surface 42.

The intensity of the electric field may be individually controlled based on each area occupied by each of the conductive plates 73 facing each other in the vertical direction while an area corresponding to the cleaning surface 42 is positioned therebetween.

There may be various schemes of applying the electric field. It is clear that the structure of the electric field applicator 70 implemented in an embodiment of the present disclosure is not limited particularly as long as the structure is capable of applying electric fields varying along the radial direction to an area corresponding to the cleaning surface 42.

For example, the electric field applicator 70 may be configured such that the electric field applicator 70 having a plurality of application areas capable of applying electric fields having different intensities may be disposed on top of the cleaning surface 42, and the wafer support 30 is grounded. In addition, various electric field application structures known in the art may be applied.

The wet-cleaning method of the wafer 10 according to the present disclosure is applied to the cleaning in the rotating scheme, as implemented in the wafer cleaning apparatus as described above.

The wet-cleaning method include applying the electric field of the intensity varying along the radial direction r around the center of rotation 30C to the ion cleaning liquid 55 supplied to the space between the surface of the wafer 10 and the cleaning tool 40. Accordingly, the viscosity of the cleaning liquid 55 may be artificially controlled based on each of the areas arranged along the radial direction, so that the cleaning may be performed uniformly on the areas having different radial distances from the rotational center 30C during the rotational cleaning.

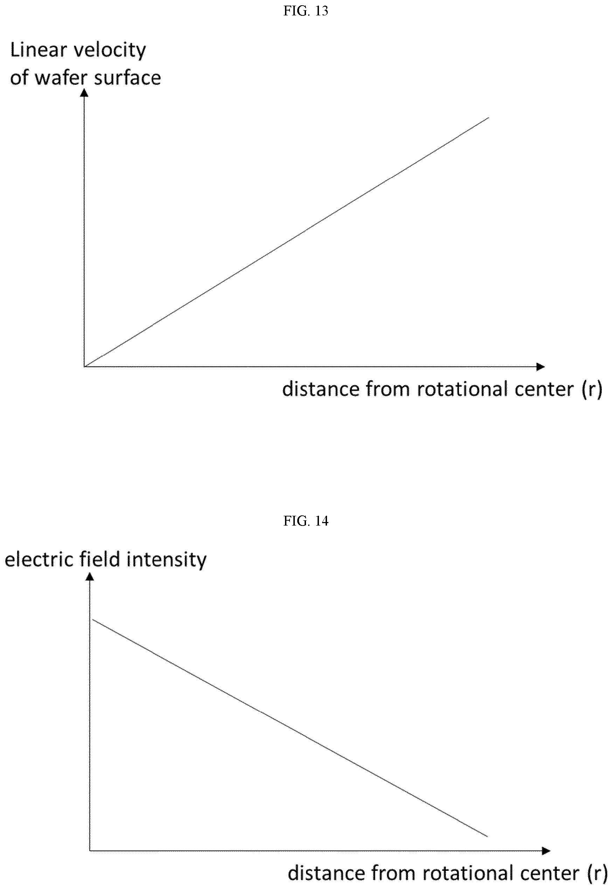

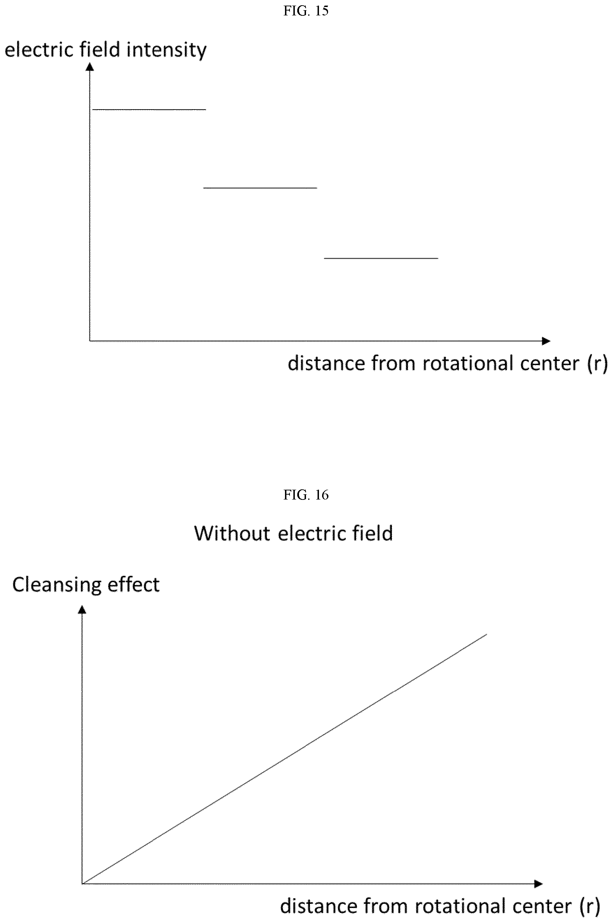

The cleaning efficiency is proportional to a flow rate of the cleaning liquid 55 and is also proportional to the viscosity of the cleaning liquid 55. That is, the higher the flow rate of the cleaning liquid 55, the higher the cleaning power. Further, the higher the viscosity of the cleaning liquid 55, the higher the cleaning power. Thus, as shown in FIG. 13 and FIG. 16, when the wafer 10 is cleaned in the rotation scheme using the cleaning liquid 55 having the same viscosity, the cleaning efficiency on the area far away from the rotational center 30C is higher than the cleaning efficiency on the area closer to the rotational center 30C. That is, the circumferential linear velocity of the surface of the wafer 10 increases as the area extends outwardly in the radial direction as shown in FIG. 13, thereby, the cleaning efficiency increases linearly increases as the area extends outwardly in the radial direction as shown in FIG. 16.

The wet-cleaning method according to the present disclosure artificially increases the viscosity of the cleaning liquid 55 existing close to the rotational center 30C in order to compensate for the difference in the cleaning efficiency based on the circumferential linear speed that varies according to the rotation radius.

When the viscosity of the cleaning liquid 55 is appropriately controlled, the cleaning may be performed at substantially uniform cleaning efficiency across all of areas having different rotation radii.

In one example, a height h of the cleaning liquid 55 filling the spacing between the surface of the wafer 10 and the cleaning surface 42 which is required to be adjusted to control the viscosity of the cleaning liquid 55 under the electric field may be determined to be a size in which van der Waals force and Coulomb force may act in an equal manner to each other. The height may be in a range of 1 nm to 20nm.

When the spacing is smaller than 1 nm, it is difficult to fill the cleaning liquid 55 within the spacing, whereas the effect of inducing the change in viscosity of the cleaning liquid 55 based on the intensity of the electric field is no longer increased. When the spacing exceeds 20nm, the cleaning liquid 55 having the height of 20nm has little change in viscosity even when the intensity of the electric field is controlled, thereby making it difficult to control the viscosity.

In consideration of the microstructure stacked on the wafer 10, preferably, the distance between the surface of the wafer 10 and the cleaning tool 40 may be in a range of 2 nm to 4 nm. More preferably, the spacing may be about 3 nm on average. When the height of the cleaning liquid 55 is set to the above range, an amount of cleaning liquid 55 required for ion transfer may be provided. Furthermore, in the above range of the height, the electric field may efficiently travel through the solution depth and affect the movement and arrangement of ions and solvent molecules. In addition, the thus limited space limits ion mobility, thereby improving the reactivity of the solvent with the applied electric field and minimizing energy consumption. Accordingly, the viscosity may be precisely controlled without reducing the concentration of the solution.

The equivalent concentration of ions contained in the cleaning liquid 55 may be in a range of 0.1Meg/L inclusive to 10 Meg/L inclusive.

When the equivalent concentration of the ions is lower than 0. 1Meg/L, there is little change in the viscosity of the cleaning liquid 55 even when the intensity of the electric field is controlled, thereby making it difficult to control the viscosity.

When the equivalent concentration of the ions is greater than 10 Meg/L, the effect of inducing a change in viscosity of the cleaning liquid 55 under the intensity of the electric field is not further increased, and there is a concern that the possibility that the ions remain as foreign substances may increase.

In one embodiment, the equivalent concentration of the ions may be in a range of 1.0Meg/L inclusive to 2.0 Meg/L inclusive. More preferably, the equivalent concentration of the ions may be about 1.5 Meg/L. The concentration of 1.5 Meg/L achieves an optimal balance between the ion density and the volume of the solution, thereby promoting an improvement in the responsiveness to the electric field while maintaining the chemical integrity of the solution. In addition, this level of concentration enables accurate viscosity adjustment without excessive dilution or concentration, and optimizes the efficiency of the viscosity control process.

In some embodiments, the cleaning liquid 55 including a H₂O solution that including cations and anions. For example, the ions may include Na⁺ and Cl⁻.

In some embodiments, in the cleaning liquid 55, the cations and the anions are equivalent to each other so that the cleaning liquid 55 is entirely neutral.

Specifically, in the wafer cleaning method, the cleaning tool 40 is disposed to face the surface of the wafer 10 requiring the cleaning, the spacing between the surface of the wafer 10 and the cleaning tool 40 is adjusted, the cleaning liquid 55 containing the ions is supplied to a space between the surface of the wafer 10 and the cleaning tool 40, the electric field is applied to the cleaning liquid 55 present in at least a portion of the area in which the cleaning liquid 55 is present, and then, the wafer 10 and the cleaning tool 40 are rotated relatively to each other to clean the surface of the wafer 10. Referring to FIG. 12, the area in which the cleaning liquid 55 is present including a first area 1^{st} area and a second area 2^{nd} disposed farther away from the rotational center 30C than the first area.

In some embodiments, when the electric field is applied to the cleaning liquid, the electric field may be applied to the first area so that the viscosity of the cleaning liquid 55 in the first area is greater than the viscosity of the cleaning liquid 55 in the second area. Thus, the viscosity of the cleaning liquid 55 in the first area may be increased to increase the cleaning efficiency of the first area.

In some embodiments, when the electric field is applied to the cleaning liquid, the intensity of the electric field applied to the first area may be greater than the intensity of the electric field applied to the second area. Thus, the viscosity of the cleaning liquid 55 in the first area may be higher than the viscosity of the cleaning liquid 55 in the second area, thereby further increasing the cleaning efficiency of the first area.

In some embodiments, in applying the electric field to the cleaning liquid, in another example, the electric field may be applied to the first area, and no electric field may be applied to the second area.

In one embodiment, the intensity distribution of the electric field applied to the area may including a first distribution in which the intensity continuously decreases as the area extends away from the rotational center 30C as shown in FIG. 14.

In one embodiment, the intensity distribution of the electric field applied to the area may including a second distribution in which the intensity gradually decreases as the area extends away from the rotational center 30C as shown in FIG. 14.

In one embodiment, the intensity distribution of the electric field applied to the area may including a third distribution in which the intensity decreases in a stepwise manner as the area extends away from the rotational center 30C as shown in FIG. 15.

In one embodiment, the intensity distribution of the electric field applied to the area may including a fourth distribution in which the intensity linearly decreases as the area extends away from the rotational center 30C as shown in FIG. 14.

In one embodiment, the intensity distribution of the electric field applied to the area may including a fifth distribution in which the intensity decreases non-linearly as the area extends away from the rotational center 30C.

In one embodiment, the intensity distribution of the electric field applied to the area may including a sixth distribution in which the intensity decreases in a parabolic shape as the area extends away from the rotational center 30C.

In one embodiment, the intensity distribution of the electric field applied to the area may including a seventh distribution in which the intensity decreases in a hyperbolic shape as the area extends away from the rotational center 30C.

According to the present disclosure, the intensity distribution of the electric field applied to the area may including any one distribution of at least among the first to seventh distributions.

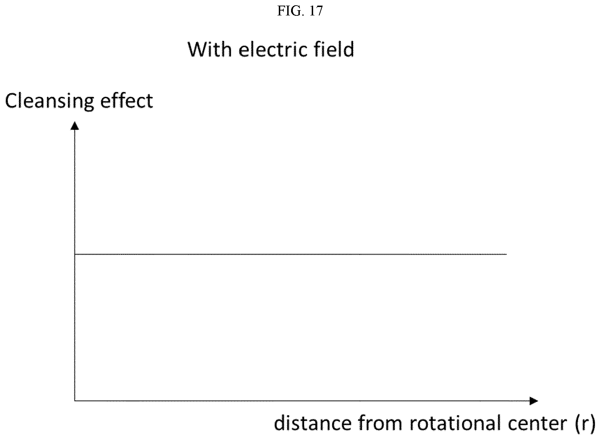

When the intensity of the electric field applied to the area varies based on the radial position of the area as described above, a difference in an electrical double layer (EDL) effect occurs, thereby inducing a difference in viscosity. Accordingly, as shown in FIG. 17, the wafer 10 may be cleansed at uniform cleaning efficiency along the radial direction. For reference, the principle of the viscosity control is based on an electroosmosis principle that forms the EDL under the electric field. In principle, the electric field may be applied based on a DC power source.

According to an embodiment, the wafer cleaning apparatus is implemented in a configuration in which the wafer 10 is rotated and the cleaning surface 42 is fixed. In addition, the wafer cleaning method is also implemented such that the wafer rotates while the cleaning surface is fixed. However, this is merely a limited example for better understanding, and any structure and method capable of relative rotation between the wafer 10 and the cleaning surface 42 are included in the technical spirit of the present disclosure.

In addition, the present disclosure proposes a principle of inducing a difference in viscosity of the cleaning liquid by applying the electric field having the varying intensity, thereby making the cleaning efficiency uniform according to the radial direction. However, the technical idea of the present disclosure is not intended to increase an entirety of the viscosity of the cleaning liquid. Therefore, an apparatus for lowering the viscosity of the entirety of the cleaning liquid may be combined with the apparatus and method for cleaning the wafer in accordance with the present disclosure. In a state in which the viscosity of the entirety of the cleaning liquid is lowered by the apparatus for lowering the viscosity of the entirety of the cleaning liquid, the viscosity of the cleaning liquid may vary based on the areas by the apparatus and method for cleaning the wafer in accordance with the present disclosure.

Although the present disclosure has been described with reference to the accompanying drawings, the present disclosure is not limited by the embodiments disclosed herein and the drawings, and it is obvious that various modifications may be made by those skilled in the art within the scope of the technical idea of the present disclosure. In addition, although the effects based on the configuration of the present disclosure are not explicitly described and illustrated in the description of the embodiment of the present disclosure above, it is obvious that predictable effects from the configuration should also be recognized.

## Claims

1. A method for wet-cleaning a wafer, the method comprising:
a first step of positioning a cleaning tool so as to face a surface of the wafer requiring cleaning;
a second step of supplying a cleaning liquid containing ions to an area between the surface of the wafer and the cleaning tool;
a third step of adjusting a spacing between the surface of the wafer and the cleaning tool so that a viscosity of the cleaning liquid present between the surface of the wafer and the cleaning tool is controlled under an electric field; and
a fourth step of rotating the wafer and the cleaning tool relatively to each other in a state in which the electric field has been applied to at least a portion of an area in which the cleaning liquid is present, thereby cleaning the surface of the wafer with the cleaning liquid.

2. The method of claim 1, wherein the area in which the cleaning liquid is present includes a first area and a second area, wherein a distance between the first area and the rotational center is smaller than a distance between the second area and the rotational center,
wherein the electric field is applied to the cleaning liquid of the first area.

3. The method of claim 2, wherein the electric field is applied to the cleaning liquid of the second area,
wherein an intensity of the electric field applied to the first area is greater than an intensity of the electric field applied to the second area.

4. The method of claim 2, wherein no electric field is applied to the second area.

5. The method any one of preceding claims, wherein an intensity distribution of the electric field applied to the area includes a distribution in which the intensity decreases as the area extends away from the rotational center.

6. The method of any one of preceding claims, wherein an intensity distribution of the electric field applied to the area includes a distribution in which the intensity continuously decreases as the area extends away from the rotational center.

7. The method of any one of preceding claims, wherein an intensity distribution of the electric field applied to the area includes a distribution in which the intensity decreases in a stepwise manner as the area extends away from the rotational center.

8. The method of any one of preceding claims, wherein an intensity distribution of the electric field applied to the area includes a distribution in which the intensity linearly decreases as the area extends away from the rotational center.

9. The method of any one of preceding claims, wherein an intensity distribution of the electric field applied to the area includes a distribution in which the intensity decreases non-linearly as the area extends away from the rotational center.

10. The method of any one of preceding claims, wherein the cleaning liquid includes a H₂O solution containing cations and anions.

11. The method of claim 10, wherein the cation and the anion include Na⁺ and Cl⁻ ions.

12. The method of claim 10 or 11, wherein an equivalent concentration of the ions contained in the cleaning liquid is in a range of 0.1Meg/L inclusive to 10 Meg/L inclusive.

13. The method of any one of preceding claims, wherein the spacing is in range of 1 nm inclusive to 20nm inclusive.

14. An apparatus for wet-cleaning a wafer, the apparatus comprising:
a wafer support for gripping the wafer;
a cleaning tool positioned to face the wafer support;
a cleaning liquid supply device for supplying a cleaning liquid containing ions to an area between the cleaning tool and the wafer support;
a spacing adjusting device for adjusting a spacing between the wafer support and the cleaning tool to adjust a height of the cleaning liquid present between a surface of the wafer and the cleaning tool;
a driver device configured to rotate the wafer support and the cleaning tool relatively to each other; and
an electric field applicator configured to apply an electric field to the cleaning liquid supplied onto the wafer.

15. The apparatus of claim 14, wherein the electric field applicator is configured to apply the electric field based on a direct current power source.

## Amended claims

### Amended claims in accordance with Rule 137(2) EPC.

1. A method for wet-cleaning a wafer, the method comprising:
positioning a cleaning tool (40) so as to face a surface of the wafer requiring cleaning;
supplying a cleaning liquid (55) containing ions to an area between the surface of the wafer and the cleaning tool (40); and
rotating the wafer and the cleaning tool (40) relatively to each other in a state in which an electric field has been applied to at least a portion of an area in which the cleaning liquid (55) is present, thereby cleaning the surface of the wafer with the cleaning liquid (55);
**characterized in that** the method further comprises:
controlling a viscosity of the cleaning liquid (55) by varying the electric field based on a radial position of the area thereby to generate a difference in an electrical double layer, EDL, effect in the cleaning liquid (55).

2. The method of claim 1, wherein the area in which the cleaning liquid (55) is present includes a first area and a second area, wherein a distance between the first area and a rotational center (30C) is smaller than a distance between the second area and the rotational center (30C),
wherein the electric field is applied to the cleaning liquid (55) of the first area.

3. The method of claim 2, wherein the electric field is applied to the cleaning liquid (55) of the second area,
wherein an intensity of the electric field applied to the first area is greater than an intensity of the electric field applied to the second area.

4. The method of claim 2, wherein no electric field is applied to the second area.

5. The method any one of preceding claims, wherein an intensity distribution of the electric field applied to the area includes a distribution in which the intensity decreases as the area extends away from the rotational center (30C).

6. The method of any one of preceding claims, wherein an intensity distribution of the electric field applied to the area includes a distribution in which the intensity continuously decreases as the area extends away from the rotational center (30C).

7. The method of any one of preceding claims, wherein an intensity distribution of the electric field applied to the area includes a distribution in which the intensity decreases in a stepwise manner as the area extends away from the rotational center (30C).

8. The method of any one of preceding claims, wherein an intensity distribution of the electric field applied to the area includes a distribution in which the intensity linearly decreases as the area extends away from the rotational center (30C).

9. The method of any one of preceding claims, wherein an intensity distribution of the electric field applied to the area includes a distribution in which the intensity decreases non-linearly as the area extends away from the rotational center (30C).

10. The method of any one of preceding claims, wherein the cleaning liquid (55) includes a H₂O solution containing cations and anions.

11. The method of claim 10, wherein the cation and the anion include Na⁺ and Cl⁻ ions.

12. The method of claim 10 or 11, wherein an equivalent concentration of the ions contained in the cleaning liquid is in a range of 0.1 1mEq/L inclusive to 10mEq/L inclusive.

13. The method of any one of preceding claims, further comprising:
adjusting a spacing between the surface of the wafer and the cleaning tool (40) to a height of the cleaning liquid (55) at which the difference of the EDL effect is generated as the electric field varies based on the radial position of the area.

14. An apparatus for wet-cleaning a wafer, the apparatus comprising:
a wafer support (30) for gripping the wafer;
a cleaning tool (40) positioned to face the wafer support (30);
a cleaning liquid supply device (50) for supplying a cleaning liquid (55) containing ions to an area between the cleaning tool (40) and the wafer support (30); and
a driver device (60) configured to rotate the wafer support (30) and the cleaning tool (40) relatively to each other;
**characterized in that** the apparatus further comprises:
an electric field applicator (70) configured to apply an electric field to the cleaning liquid (55) supplied onto the wafer, and to vary the electric field based on a radial position of the area thereby generating a difference in an electrical double layer, EDL, effect in the cleaning liquid (55).

15. The apparatus of claim 14, further comprising a spacing adjusting device (80) for adjusting a spacing between the wafer support (30) and the cleaning tool (40) to a height of the cleaning liquid (55) at which the difference of the EDL effect is generated as the electric field varies based on the radial position of the area.
